(19) Europäisches Patentamt
European Patent Office
Office européen des brevets

(11) EP 1 011 200 B1

(12) FASCICULE DE BREVET EUROPEEN

(45) Date de publication et mention de la délivrance du brevet:
**29.10.2003 Bulletin 2003/44**

(51) Int Cl.$^7$: **H03M 3/02**

(21) Numéro de dépôt: **99403090.6**

(22) Date de dépôt: **09.12.1999**

# (54) Circuit électronique de conversion numérique-analogique pour une chaine de transmission en bande de base

Elektronische Digital-Analog Wandleranordnung für eine Basisbandübertragungskette

Electronic digital-to-analogue conversion circuit for a baseband transmission chain

(84) Etats contractants désignés:
**AT BE CH CY DE DK ES FI FR GB GR IE IT LI LU MC NL PT SE**

(30) Priorité: **14.12.1998 FR 9815743**

(43) Date de publication de la demande:
**21.06.2000 Bulletin 2000/25**

(73) Titulaire: **ALCATEL**
**75008 Paris (FR)**

(72) Inventeurs:
- **Yang, Fuji**
  **92110 Clichy (FR)**
- **Maecker, Arnaud**
  **92600 Asnières (FR)**

(74) Mandataire: **Lamoureux, Bernard**
**Compagnie Financière Alcatel**
**Département de Propriété Industrielle,**
**5, rue Noel Pons**
**92734 Nanterre Cedex (FR)**

(56) Documents cités:
**EP-A- 0 642 221**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 1 011 200 B1

Printed by Jouve, 75001 PARIS (FR)

## Description

La présente invention se rapporte à un circuit électronique de conversion numérique-analogique pour une chaîne de transmission en bande de base.

Plus particulièrement, l'invention concerne un circuit électronique de conversion numérique-analogique pour transformer sans distorsion de phase un signal numérique en un signal analogique, comprenant notamment un modulateur de type sigma-delta et un filtre à réponse impulsionnelle finie.

Un domaine d'application préféré de l'invention est le domaine de la téléphonie mobile. La description de l'invention se fera essentiellement dans le cadre de ce domaine. La portée de l'invention ne devra cependant pas être limitée au domaine de la téléphonie mobile, mais devra être comprise comme s'étendant à tout autre domaine mettant en application le circuit de conversion et le procédé de conversion selon l'invention.

Le plus souvent, un téléphone portable, ou téléphone sans fil, peut être structurellement divisé en quatre blocs distincts : le bloc utilisateur ou interface utilisateur, le bloc de contrôle, le bloc audio, et le bloc radio-fréquence. Les trois derniers blocs cités constituent l'unité radio du téléphone portable.

La figure 1 montre un schéma bloc illustrant une structure générale 100 d'un téléphone portable. La structure générale 100 est composée des quatre principaux blocs qui viennent d'être cités. L'utilisateur d'un téléphone portable a accès à une interface d'utilisation 120. L'interface d'utilisation 120 comprend le plus souvent un haut-parleur 121, un microphone 122, un pavé numérique 123 et un moyen d'affichage 124. L'interface d'utilisation 120 peut accessoirement comporter d'autres éléments, par exemple un modem pour effectuer des transferts de données.

Une unité radio 130 comporte les blocs nécessaires pour la transmission en bande de base : des moyens de codage de la parole, des moyens de compression d'informations en blocs de données, des moyens de décompression de ces blocs de données en signal continu. Ces éléments, ainsi que d'autres, se repartissent entre un bloc de contrôle 140, un bloc audio 150 et un bloc de radio-fréquence 160.

Le bloc de contrôle 140 comprend un microprocesseur 141 qui fait office d'unité centrale de traitement. Le microprocesseur 141 effectue les procédures nécessaires pour l'établissement d'une communication. Il contrôle par ailleurs les diverses opérations du téléphone portable au moyen de programmes divers. Parmi ces programmes, on trouvé par exemple des programmes de gestion de l'interface d'utilisation 120, des programmes dits de surveillance (notamment du niveau de la batterie) ou encore des programmes de test afin de faciliter la maintenance du téléphone portable. D'autres programmes gèrent la connexion entre le téléphone portable et le relai de transmission le plus proche. Les programmes associés à l'interface d'utilisation 120 gèrent notamment des interactions entre l'utilisateur et les autres programmes, notamment en interprétant les informations fournies par l'utilisateur au microprocesseur 141 au moyen du pavé numérique 123 et d'une liaison 101, et en contrôlant le moyen d'affichage 124 au moyen d'une liaison 102.

Le bloc de contrôle 140 comprend également des mémoires 142 qui sont utilisées dans les téléphones portables pour mémoriser notamment le système d'exploitation, le numéro de série et le numéro de téléphone associés au téléphone portable ou encore des droits d'exploitation pour des services variés. Ces mémoires 142 peuvent également servir lors de l'établissement d'un appel. L'échange d'informations de données, d'adresses mémoire et de commande entre les mémoires 142 et le microprocesseur 141 est assuré par un bus bidirectionnel 103.

Le bloc audio 150 est essentiellement constitué d'une unité de traitement du signal 151 qui a recours à de nombreux programmes. L'unité de traitement du signal 151 reçoit des informations du microphone 122 au moyen d'une liaison 104. Une liaison 105 assure la transmission de signaux entre l'unité de traitement du signal 151 et le haut-parleur 121. Par ailleurs, l'échange d'informations entre l'unité de traitement du signal 151 et le microprocesseur 141 est réalisé par une liaison bidirectionnelle 106.

La communication avec l'unité radio 130 du téléphone portable s'effectue au moyen de l'interface particulière de radio-fréquence 160 dans laquelle les conversions analogiques-numériques et numériques-analogiques sont effectuées. Le bloc de radio-fréquence 160 comprend notamment une antenne 161 reliée à un duplexeur 162, un émetteur 163, un récepteur 164 et une unité de génération de fréquence 165. Le microprocesseur 141 gère le fonctionnement de l'émetteur 163, du récepteur 164 et du générateur de fréquence 165, respectivement au moyen de connexions 107, 108 et 109. L'unité de traitement du signal 151 peut transmettre des signaux à l'émetteur 163 et recevoir des signaux du récepteur 164 respectivement au moyen de liaisons 110 et 111. Le générateur de fréquence 165 est connecté à l'émetteur 163 et au récepteur 164 respectivement au moyen de connexions 112 et 113. Le duplexeur 162 reçoit des signaux de l'émetteur 163 au moyen d'une liaison 114 et transmet des signaux au récepteur 164 au moyen d'une liaison 115.

Dans l'émetteur 163, les signaux porteurs des informations de parole et d'autres informations nécessaires à la télécommunication sont modulés afin d'être transmis au moyen d'une onde porteuse de fréquence radio. Les opérations de modulation sont habituellement effectuées à une fréquence intermédiaire qui est mélangée à la fréquence de transmission désirée. Diverses méthodes de modulation sont connues. Elles dépendent du type de signal et des équipements dont on dispose pour la transmission. Pour la transmission d'informations analogiques, il est possible d'utiliser une modulation de fréquence ou une modulation par déplacement de fréquence, par exemple de type FSK (Frequency Shift Keying dans la littérature anglaise) ; pour les transferts d'informations numériques, il est possible d'utiliser une modulation par déplacement de phase, par exemple de type π/4 PSK (π/4 - Phase Shift Keying dans la littérature anglaise), ou encore une modulation de type GMSK (Gaussian Minimum Shift Keying dans la littérature anglaise).

La figure 2 représente un schéma bloc simplifié d'une chaîne de transmission de l'émetteur 163, et plus particulièrement d'un circuit de conversion numérique-analogique de l'état de la technique. Le signal issu de l'unité de traitement du signal 151 est transmis sous forme de données numériques à une interface 210 de l'émetteur 163. Le signal numérique reçu par l'émetteur 163 est successivement traité par l'interface 210, un modulateur 220 effectuant une modulation de type GMSK, un convertisseur numérique-analogique 240 appelé DAC, un échantillonneur-bloqueur 230 et un filtre analogique 250.

Dans l'état de la technique, pour des raisons de consommation et de facilité de réalisation, le DAC 240 est le plus souvent un DAC à capacité commutée. Ainsi, par exemple, pour chaque groupe de k bits issus du modulateur 220, une tension proportionnelle à la valeur codée sur les k bits est directement produite en sortie du DAC 240. Ce procédé pose des problèmes de linéarité entre le signal issu du DAC 240 et le signal en entrée du DAC 240. Ces problèmes de linéarité sont encore accrus du fait de l'existence dans la chaîne de transmission décrite de l'échantillonneur-bloqueur 230. En effet, le DAC 240 est un convertisseur numérique-analogique à capacité commutée. Ceci signifie que pendant une demi-période d'un signal d'horloge cyclique régissant le transfert de données de la chaîne de transmission décrite, la valeur de chaque bit traitée par le DAC 240 n'est plus disponible. L'échantillonneur-bloqueur 230 est donc nécessaire pour maintenir, pendant au moins une demi-période du signal d'horloge, la valeur de chaque bit traité. La présence de l'échantillonneur-bloqueur 230 accroît cependant les problèmes de non linéarité dans la transmission du signal. Or dans certains émetteurs, et notamment les émetteurs intervenant dans les systèmes de téléphonie mobile de type GSM, les distorsions des signaux transmis sont très gênants pour la qualité de la télécommunication.

Dans l'état de la technique, notamment le brevet EP A-0642221, un circuit électrique de conversion numérique-analogique, pour une chaîne de transmission en bande de base, est décrit. Ce circuit comporte un interpolateur pour augmenter une fréquence d'échantillonnage du signal numérique, un modulateur de type sigma-delta, un bloc de conversion numérique-analogique comprenant un filtre à réponse impulsionnelle finie (ou FIR), et enfin un filtre analogique de type filtre passe-bas.

Cependant, le FIR décrit dans ce document est un FIR classique, c'est à dire dont la fonction de transfert est du type $h(z) = 1 + a_1z^{-1} + a_2z^{-2} + a_3z^{-3} + ...$ Un tel filtre n'est pas adapté à une application dans le domaine GSM car il nécessiterait un nombre de coefficients $a_i$ importants résultant dans un FIR volumineux et une consommation électrique importante, pour obtenir un filtre à pente raide.

La présente invention permet de pallier les insuffisances des systèmes de l'état de la technique qui viennent d'être décrits et permet notamment d'obtenir un filtre à pente raide dont la taille est plus réduite que celle des convertisseurs numérique-analogiques de l'état de la technique.

L'invention a pour objet un circuit électronique de conversion numérique-analogique, pour une chaîne de transmission en bande de base, pour transformer sans distorsion de phase un signal numérique en un signal analogique comprenant :

- un modulateur numérique délivrant un signal sous forme de groupes de n bits,
- un interpolateur pour augmenter une fréquence d'échantillonnage du signal numérique,
- un modulateur de type sigma-delta pour transformer un signal n bits en un signal 1 bit,
- un bloc de conversion numérique-analogique, notamment pour filtrer de façon précise un bruit de quantification, qui comprend un convertisseur numérique-analogique et un filtre à réponse impulsionnelle finie,
- un filtre analogique de type filtre passe-bas, circuit électronique caractérisé en ce que le filtre à réponse impulsionnelle finie est un filtre multi-bande.

Les différents aspects et avantages de l'invention apparaîtront plus clairement dans la suite de la description en référence aux figures qui ne sont données qu'à titre indicatif et nullement limitatif de l'invention et qui sont à présent introduites :

- la figure 1, déjà décrite, montre un schéma-bloc illustrant la structure générale d'un téléphone portable,
- la figure 2, déjà décrite, montre un schéma-bloc d'un circuit électronique de conversion numérique-analogique de l'état de la technique,
- la figure 3 montre un schéma-bloc d'un circuit électronique selon l'invention,
- la figure 4 montre un schéma-bloc d'un modulateur sigma-delta,
- la figure 5 montre des spectres de fréquence du signal transmis en certains points du circuit électronique selon l'invention lors de la transmission d'un signal.

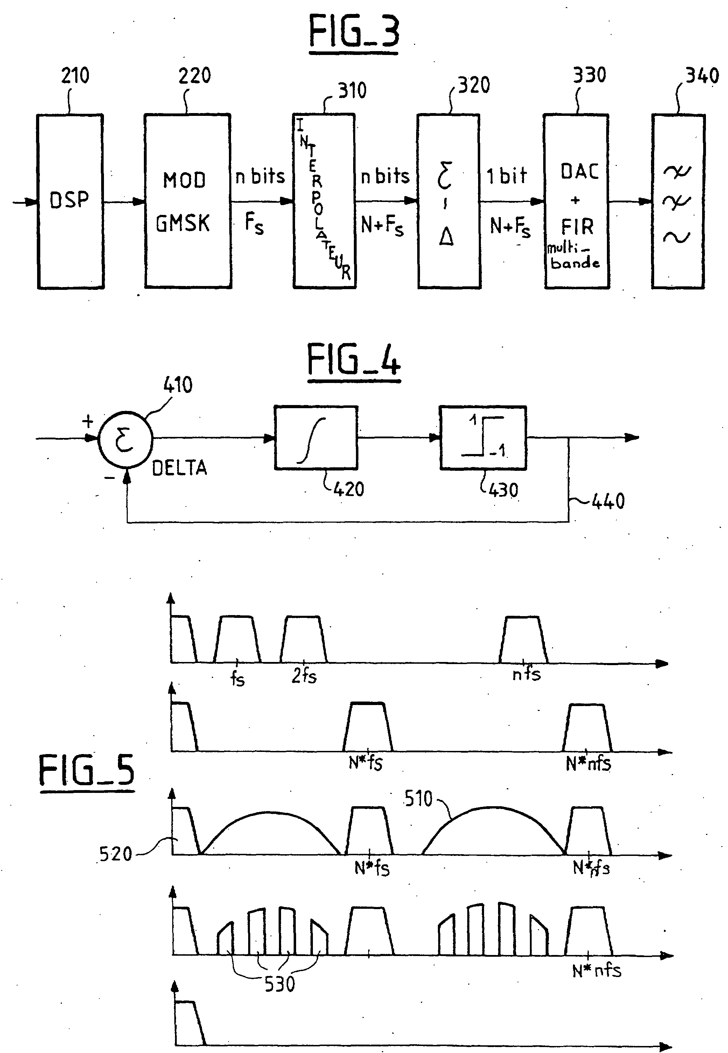

A la figure 3, on retrouve l'interface 210 qui reçoit le signal issu de l'unité de traitement du signal 151 et qui était déjà présente dans la chaîne de transmission de l'art antérieur présenté à la figure 2. On retrouve également le modulateur de type GMSK 220. Le signal issu du modulateur 220 est successivement traité par les éléments suivants : un interpolateur 310, un modulateur de type sigma-delta 320, un bloc de conversion numérique-analogique 330 et enfin un filtre analogique 340. Le rôle de chacun de ces éléments va à présent être plus précisément décrit:

Le modulateur 320 est appelé modulateur sigma-delta. La figure 4 montre un schéma bloc d'un tel modulateur. Le nom sigma-delta vient de la configuration même du modulateur qui fait intervenir tout d'abord un additionneur 410, qui est habituellement symbolisé par la lettre grecque "sigma". En sortie de l'additionneur 410 on trouve un élément intégrateur 420 réalisant l'intégration du signal. L'élément intégrateur 420 joue le rôle d'un filtre passe-bas pour le signal d'entrée utile. L'élément intégrateur 420 est suivi par un quantificateur 430, dont le principe de base est de réaliser une quantification résultant de la différence entre deux échantillons consécutifs du signal numérique traité. C'est de cette différence que vient le terme "delta", conformément à la désignation courante d'une telle opération. Une boucle de contre-réaction 440 joue le rôle d'un filtre passe-haut pour le bruit de quantification généré par le quantificateur 430. Le modulateur de type sigma-delta permet de rejeter le bruit de quantifcation dans les hautes fréquences, alors que le signal utile est présent dans les basses fréquences.

Dans les chaînes de conversion numérique-analogique comprenant un modulateur de type sigma-delta, la fréquence d'échantillonnage est d'abord augmentée. Cette opération est ici réalisée par l'interpolateur 310. L'interpolateur permet de réaliser une opération de suréchantillonnage.

Dans une application préférée de l'invention, la fréquence d'échantillonnage des données issues du modulateur de type GMSK k est doublée grâce à une interpolation de type linéaire : entre deux données consécutives issues du modulateur de type GMSK 220, on ajoute une donnée supplémentaire correspondant à une moyenne des deux données directement voisines dans le temps. La fréquence d'échantillonnage est ensuite triplée en entrée du modulateur de type sigma-delta en répétant chaque donnée trois fois.

L'interpolateur 310 permet donc de passer d'un signal n bits échantillonné à une fréquence Fs à un signal n bits échantillonné à une fréquence N x Fs où N est un entier naturel. Dans une application préférée, N=6 et n=8.

Le modulateur de type sigma-delta 320 associé à l'interpolateur 310 permet de passer d'un signal n bits échantillonné à la fréquence N x Fs à un signal 1 bit échantillonné à la fréquence N x Fs.

Le signal 1 bit issu du modulateur sigma-delta 320 peut être un signal modulé en largeur d'impulsion (signal PDM, Pulse Duration Modulation dans la littérature anglaise). Il est fourni en entrée du bloc de conversion numérique-analogique. Le signal en sortie du modulateur sigma-delta 320 fournit donc au bloc de conversion numérique-analogique 330 moins d'informations, puisque le nombre de bits est réduit, mais à une fréquence plus élevée du fait du suréchantillonnage effectué par l'interpolateur 310.

Le bruit de quantification généré en sortie du modulateur de type sigma-delta est important car le signal est désormais codé sur un unique bit. Le bloc de conversion numérique-analogique 330 a pour but de filtrer ce bruit de quantification. Le bloc de conversion numérique-analogique 330 est composé d'un convertisseur numérique-analogique 1 bit, ou DAC 1 bit, et d'un filtre à réponse impulsionnelle finie.

La sortie du DAC 1 bit active le filtre à réponse impulsionnelle finie qui lui succède. Le FIR comprend des sources de courant. Chaque bit en entrée du DAC 1 bit contrôle une source de courant, après traitement faisant intervenir notamment des registres à décalage. Chaque source de courant est associée à un coefficient du filtre à réponse impulsionnelle finie. Chaque source de courant délivre un courant proportionnel à un coefficient du FIR.

L'utilisation d'un DAC 1 bit, comme c'est le cas dans l'invention, permet de résoudre les problèmes de non-linéarité lors de la transmission du signal dans la chaîne de conversion numérique-analogique.

Cependant, afin de filtrer le bruit de quantification important, le filtre à réponse impulsionnelle finie doit avoir une fréquence de coupure proche de la fréquence de bande de base (typiquement 100 kilohertz pour une utilisation dans le cadre d'un GSM). Ceci signifie que la représentation de la fonction de transfert du filtre FIR doit présenter une pente très raide autour de 100 kHz. Or ceci n'est réalisable qu'avec un filtre FIR classique complexe, et par conséquent présentant un grand nombre de coefficient. Le nombre de sources de courant qui devraient intervenir serait de ce fait augmenté. Cette solution augmenterait la consommation d'énergie électrique lors de la transmission du signal, et nécessiterait un espace de réalisation plus important.

Conformément à l'invention, le filtre à réponse impulsionnelle finie est un filtre multi-bande. Ce FIR présente comme avantage l'élimination de toutes les fréquences proches du signal sans en détériorer les phases, comme le montre le 4$^{ième}$ spectre de la figure 5 où le bruit de quantification 530 est filtré pour les fréquences voisines du signal, mais présente également l'avantage d'avoir une taille beaucoup plus réduite qu'un FIR classique.

Par ailleurs, un filtre FIR multibande est un filtre simple à réaliser du fait de son faible nombre de coefficients, et par conséquent du faible nombre de sources de courant mises en jeu. Il présente les caractéristiques d'avoir une fonction de transfert dont la représentation graphique présente une forte pente pour une basse fréquence, tout en laissant passer de façon périodique des fréquences plus importantes.

Les fréquences plus importantes qui ne sont pas filtrées par le filtre FIR multi-bande sont filtrées à l'aide d'un simple filtre passe-bas, tel que le filtre analogique 340 de la figure 3.

La présence du filtre FIR multi-bande permet d'autre part d'éviter la présence, dans la chaîne de transmission du signal, d'un filtre analogique complexe qui serait susceptible d'introduire une distorsion de phase.

La figure 5 montre des spectres de fréquence du signal transmis en certains points du circuit électronique selon l'invention.

Les cinq spectres de fréquence représentés sont les spectres de fréquence, en étudiant la figure 5 de haut en bas, qui sont observés respectivement en entrée de l'interpolateur 210, en sortie de l'interpolateur 210, en sortie du modulateur sigma-delta 320, en sortie du bloc de conversion numérique-analogique 330 et en sortie du filtre analogique 340.

On observe bien, sur le spectre de fréquence du signal issu du modulateur sigma-delta 320, que le spectre de fréquence 510 du bruit de quantification est rejeté dans les hautes fréquences par rapport au spectre de fréquence 520 du signal utile. Sur le spectre de fréquence du signal issu du bloc de conversion numérique-analogique, on observe bien que le filtre FIR multi-bande utilisé selon l'invention laisse passer des bandes de fréquence 530, et que par conséquent le bruit de quantification n'est pas parfaitement filtré, mais que les fréquences immédiatement voisines des fréquences du signal utile sont filtrées.

Le filtre analogique 340 qui suit peut donc être un filtre facile à réaliser. Le circuit électronique selon l'invention est économique en terme d'espace de réalisation.

Dans l'état de la technique, les circuits de compensation interviennent une fois que le signal est transformé en signal analogique. En effet, la présence des circuits de compensation dans la partie numérique nécessite l'ajout de bits au signal à traiter, et accentue par conséquent les problèmes de linéarité dans la transmission du signal.

Dans une application préférée de l'invention le modulateur de type sigma-delta a une fonction de transfert $h_1(z) = 1-2z^{-1}+z^{-2}$.

Dans une application préférée de l'invention la fonction de transfert du filtre FIR est :

$$h_2(z) = -1+z^{-14}+2,74z^{-21}+4,85z^{-28}+5,76z^{-35}+4,85z^{-42}+2,74z^{-49}+z^{-57}-z^{-71}.$$

Le filtre FIR ne présente dans ce cas que neuf coefficients. Il est par conséquent simple à réaliser. Un tel filtre présente également l'avantage d'être économique en terme d'espace nécessaire à sa réalisation.

## Revendications

1. Circuit électronique de conversion numérique-analogique, pour une chaîne de transmission en bande de base, pour transformer sans distorsion de phase un signal numérique en un signal analogique comprenant :

   - un modulateur numérique (220) délivrant un signal sous forme de groupes de n bits,
   - un interpolateur (310) pour augmenter une fréquence d'échantillonnage (Fs) du signal numérique,
   - un modulateur de type sigma-delta (320) pour transformer un signal n bits en un signal 1 bit,
   - un bloc de conversion numérique-analogique (330), notamment pour filtrer de façon précise un bruit de quantification, qui comprend un convertisseur numérique-analogique et un filtre à réponse impulsionnelle finie,
   - un filtre analogique (340) de type filtre passe-bas,

   **caractérisé en ce que** ledit filtre à réponse impulsionnelle finie est un filtre multi-bande.

2. Circuit électronique selon la revendication 1 **caractérisé en ce que** le convertisseur numérique-analogique est un convertisseur numérique-analogique 1 bit délivrant un signal modulé en largeur d'impulsions.

3. Circuit électronique selon l'une des revendications 1 à 2 **caractérisé en ce que** le filtre à réponse impulsionnelle finie comprend des sources de courant délivrant des courants proportionnels à des coefficients définissant le filtre.

4. Circuit électronique selon l'une des revendications 1 à 3 **caractérisé en ce que** le modulateur de type sigma-delta (320) a une fonction de transfert $h_1(z)= 1-2z^{-1} + z^{-2}$.

5. Circuit électronique selon l'une des revendications 2 à 4 **caractérisé en ce que** le filtre à réponse impulsionnelle finie à une fonction de transfert $h_2(z)=-1+z^{-14}+2,74z^{-21}+4,85z^{-28}+5,76z^{-35}+4,85z^{-42}+2,74z^{-49}+z^{-57}-z^{-71}$.

6. Circuit électronique selon l'une des revendications 1 à 5 **caractérisé en ce que** l'interpolateur (310) multiplie par 6 la fréquence d'échantillonnage (Fs).

7. Utilisation du circuit de conversion numérique-analogique selon l'une des revendications précédentes dans un téléphone portable.

**Patentansprüche**

1. Elektronische Digital-Analog-Wandleranordnung für eine Basisbandübertragungskette zur phasenverzerrungsfreien Umsetzung eines digitalen Signals in ein Analogsignal, beinhaltend

   - einen digitalen Modulator (220), der ein Signal in Form einer Gruppe von n Bits liefert,
   - einen Interpolator (310) zur Erhöhung der Abtastfrequenz Fs des digitalen Signals,
   - einen Sigma-Delta-Modulator (320) zur Umsetzung eines Signals von n Bits in ein 1-Bit-Signal,
   - eine Digital-Analog-Wandlerbaugruppe (330), insbesondere zur präzisen Ausfilterung von Quantisierungsrauschen, bestehend aus einem Digital-Analog-Wandler und einem nichtrekursiven Filter, sowie
   - ein analoges Tiefpaßfilter (340),

   **dadurch gekennzeichnet, daß** das besagte nichtrekursive Filter ein Mehrbandfilter ist.

2. Elektronische Schaltung gemäß Anspruch 1, **dadurch gekennzeichnet, daß** der Digital-Analog-Wandler ein 1-Bit-Digital-Analog-Wandler ist und ein impulshöhenmoduliertes Signal liefert.

3. Elektronische Schaltung gemäß einem oder beiden der Ansprüche 1 und 2, **dadurch gekennzeichnet, daß** das nichtrekursive Filter Stromquellen beinhaltet, die Ströme proportional zu den Koeffizienten liefern, welche das Filterverhalten definieren.

4. Elektronische Schaltung gemäß einem oder mehreren der Ansprüche 1 bis 3, **dadurch gekennzeichnet, daß** der Sigma-Delta-Modulator (320) eine Übertragungsfunktion $h_1(z)=1-2z^{-1} + z^{-2}$ hat.

5. Elektronische Schaltung gemäß einem oder mehreren der Ansprüche 1 bis 4, **dadurch gekennzeichnet, daß** das nichtrekursive Filter eine Übertragungsfunktion $h_2(z)=-1+z^{-14}+2{,}74z^{-21}+4{,}85z^{-28}+5{,}76z^{-35}+4{,}85z^{-42}+2{,}74z^{-49}+z^{-57}-z^{-71}$ hat.

6. Elektronische Schaltung gemäß einem oder mehreren der Ansprüche 1 bis 5, **dadurch gekennzeichnet, daß** der Interpolator (310) die Abtastfrequenz (Fs) um den Faktor 6 vervielfacht.

7. Elektronische Schaltung zur Digital-Analog-Wandlung gemäß einem oder mehreren der vorgenannten Ansprüche in einem tragbaren Telefon.

**Claims**

1. An electronic digital-to-analog converter circuit for a baseband transmission system to transform a digital signal into an analog signal without phase distortion, the system comprising:

   · a digital modulator (220) delivering a signal in the form of groups of n bits;
   · an interpolator (310) for increasing a sampling frequency (Fs) of the digital signal;
   · a sigma-delta type modulator (320) for transforming an n-bit signal into a 1-bit signal;
   · a digital-to-analog converter block (330), specifically for filtering out quantization noise in sharp manner, which block comprises a digital-to-analog converter and a finite impulse response filter; and
   · an analog filter (340) of lowpass filter type,

   the electronic circuit being **characterized in that** the finite impulse response filter is a multiband filter.

2. An electronic circuit according to claim 1, **characterized in that** the digital-to-analog converter is a 1-bit digital-to-analog converter delivering a pulse duration modulated signal.

3. An electronic circuit according to claim 1 or 2, **characterized in that** the finite impulse response filter comprises current sources delivering currents that are proportional to coefficients defining the filter.

4. An electronic circuit according to any one of claims 1 to 3, **characterized in that** the sigma-delta type modulator (320) has the following transfer function: $h_1(z) = 1-2z^{-1}+z^{-2}$.

5. An electronic circuit according to any one of claims 2 to 4, **characterized in that** the finite impulse response filter has the following transfer function:

$$h_2(z) = -1+z^{-14}+2.74z^{-21}+4.85z^{-28}+5.76z^{-35}+4.85z^{-42}+2.74z^{-49}+z^{-57}-z^{-71}.$$

6. An electronic circuit according to any one of claims 1 to 5, **characterized in that** the interpolator (310) multiplies the sampling frequency (Fs) by six.

7. The use of the digital-to-analog converter circuit according to any preceding claim in a mobile telephone.

FIG_1

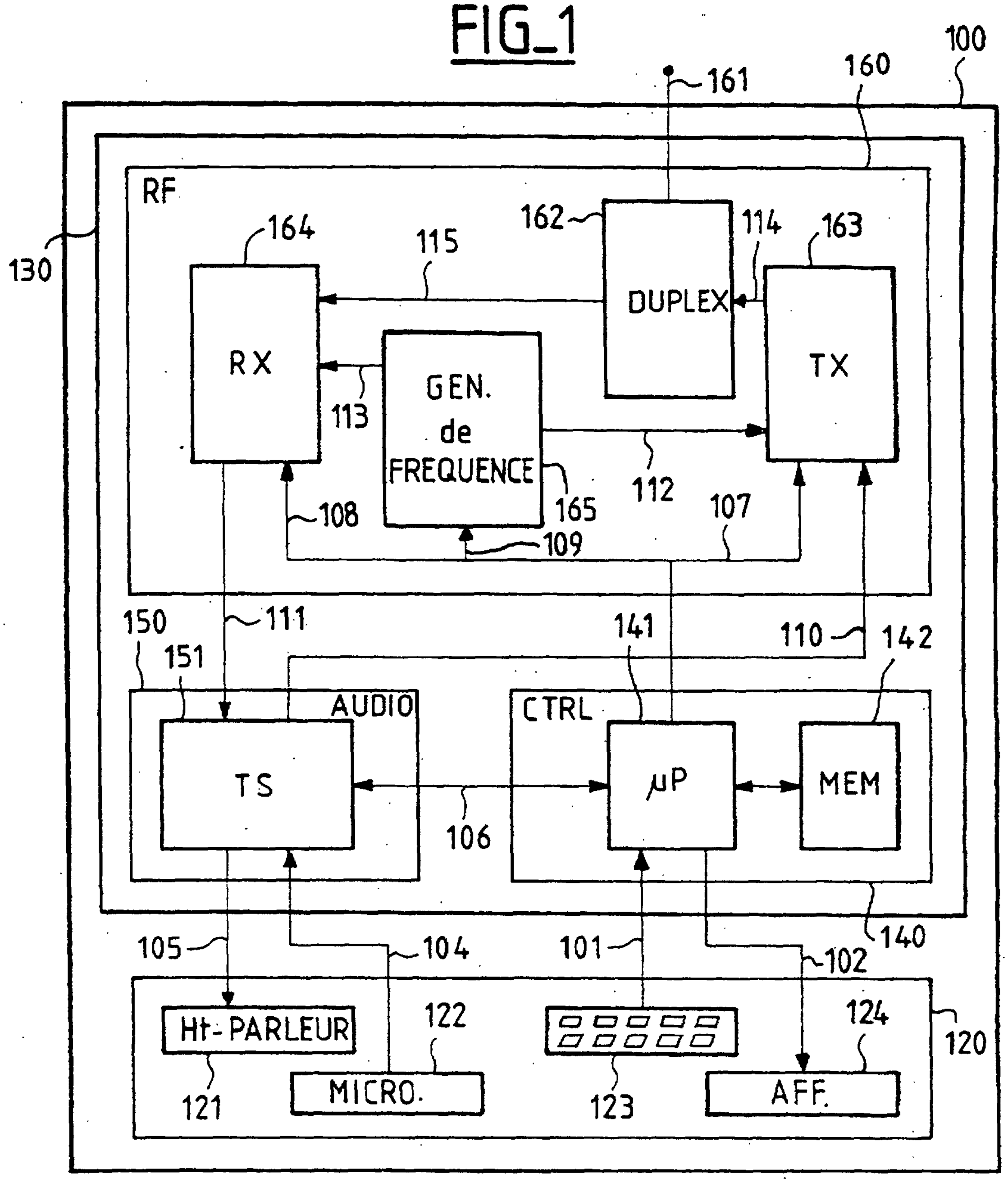
100
160
161
130
RF
164
115
162
114
163
DUPLEX
RX
TX
GEN.
de
FREQUENCE
113
112
165
107
108
109
150
111
141
110
142
151
AUDIO
CTRL
TS
µP
MEM
106
140
105
104
101
102
Ht-PARLEUR
122
124
120
MICRO.
AFF.
121
123

FIG_2

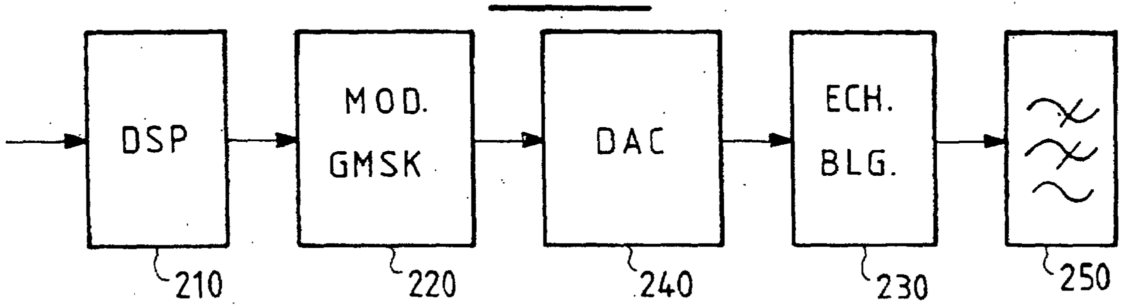
DSP
MOD.
GMSK
DAC
ECH.
BLG.
210
220
240
230
250

FIG_3

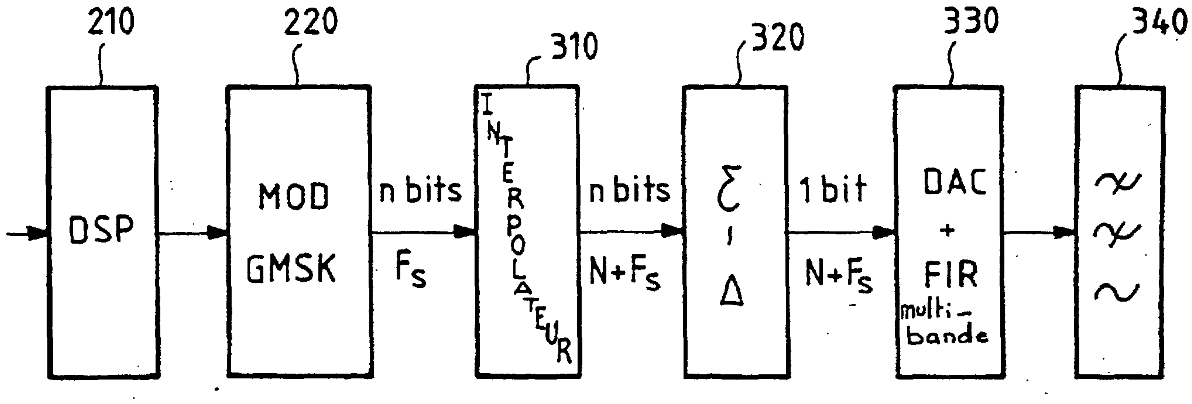


FIG_4

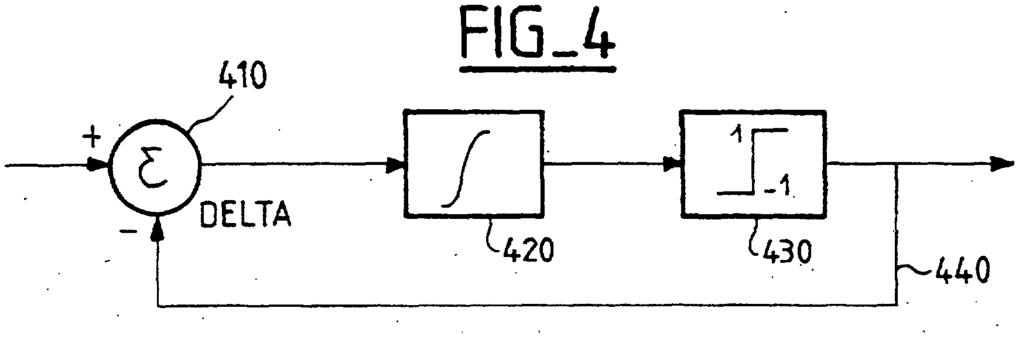


FIG_5